(19) Europäisches Patentamt
European Patent Office
Office européen des brevets

(11) EP 4 734 278 A1

(12) EUROPEAN PATENT APPLICATION

(43) Date of publication:
29.04.2026 Bulletin 2026/18

(21) Application number: 24306784.0

(22) Date of filing: 23.10.2024

(51) International Patent Classification (IPC):
H01P 5/16 (2006.01)

(52) Cooperative Patent Classification (CPC):
H01P 5/16

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: NXP B.V.
5656 AG Eindhoven (NL)

(72) Inventors:
• van der Heijden, Mark Pieter
5656 AG Eindhoven (NL)

• Lancon, Leo Lucas
31023 Toulouse Cedex 1 (FR)
• Yang, Xin
5656 AG Eindhoven (NL)
• Pruvost, Sebastien
31023 Toulouse Cedex 1 (FR)

(74) Representative: Schmütz, Christian Klaus
Johannes
NXP Semiconductors Germany GmbH
Intellectual Property Group
Beiersdorfstr. 12
22529 Hamburg (DE)

(54) **DIFFERENTIAL POWER DIVIDER/COMBINER WITH CROSSING POSITIVE AND NEGATIVE PORTIONS**

(57)    Wilkinson power dividers (100, 200, 300, 400) (or combiners) include a first positive output terminal (106, 306) and a second positive output terminal (110, 310) connected to a positive trace in a first plane and a first negative output terminal (108, 308) and a second negative output terminal (112, 312) connected to a negative trace in a second plane spaced apart from the first plane, e.g., in different circuit layers, with minimal overlap and crossings of positive and negative portions of the traces near the midpoints (222, 422) of the traces. The positive and negative traces are substantially symmetric to one another, and cascading various ones of the power dividers disclosed herein enables implementation of N-way Wilkinson power dividers.

FIG. 2

EP 4 734 278 A1

**Description**

BACKGROUND

The present disclosure relates generally to a Wilkinson divider, which can function both as a power splitter or power combiner in, but not limited to, a radio frequency (RF) implementation. In the field of RF and microwave engineering, the Wilkinson power divider is a specific class of power divider circuit that can achieve isolation between output ports while maintaining a matched condition on all ports such that the impedance of the source and the load are substantially equal to maximize power transfer and minimize reflections at a desired operating frequency range. A conventional Wilkinson power divider splits an input signal into two equal phase output signals or combines two equal-phase signals into one signal. Thus, Wilkinson power dividers are typically reversible and often referred to as either a Wilkinson power splitter or combiner depending on how they are utilized in a circuit.

Conventional Wilkinson power dividers are easily implemented using printed components on a printed circuit board utilizing quarter wave ($\lambda$/4) transmission lines (TLs) to implement the required power combination or power split at a specific frequency. Typical designs use quarter wavelength transformers to split an input signal and to provide two output signals that are in phase. At lower frequencies, this implementation can be bulky in size due to required dimensions of the $\lambda$/4 TLs. Accordingly, such an implementation of the Wilkinson power divider tends to be used more often at higher, e.g., microwave, frequencies where the $\lambda$/4 transmission line lengths are not prohibitively large. Other designs use "lumped" element configurations that utilize, e.g., discrete circuit elements. "Lumped" element designs use discrete components such as resistors, capacitors, and inductors, which are treated as individual, concentrated circuit elements. In contrast with distributed elements based on TL theory that spread a circuit's reactive components over a length of TL, lumped elements are considered to have all their properties (resistance, capacitance, or inductance) concentrated at a single point or in discrete components. However, the use of lumped element components also makes accurate amplitude and phase matching of output ports more difficult due to different component tolerances.

BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.

FIG. 1 is a circuit diagram of a two-way differential power divider in accordance with some embodiments.

FIG. 2 is a top view of a two-way differential power divider in accordance with some embodiments.

FIG. 3 is a circuit diagram of a three-way differential power divider using a star-connected isolation network in accordance with some embodiments.

FIG. 4 is a top view of a three-way differential power divider in accordance with some embodiments.

FIG. 5 is a flow diagram of a method of assembling a differential power divider in accordance with some embodiments.

FIG. 6 is a flow diagram of a method of arranging traces in a differential power divider in accordance with some embodiments.

SUMMARY OF EMBODIMENTS

In a first example embodiment, a differential Wilkinson power divider includes an input shunt capacitor between a positive input terminal and a negative input terminal; a first isolation capacitor between a first positive output terminal and a second positive output terminal; and a second isolation capacitor between a first negative output terminal and a second negative output terminal, where the first positive output terminal and the second positive output terminal are connected to a first trace in a first plane, and the first negative output terminal and the second negative output terminal are connected to a second trace in a second plane spaced apart from the first plane. In some embodiments, the power divider is configured to function as a low-pass filter. In some embodiments, the power divider further includes a third positive output terminal and a third negative output terminal corresponding to the third positive output terminal; and a first delta- or star-connected isolation network connected between the first positive output terminal, the second positive output terminal, and the third positive output terminal, where the first delta- or star-connected isolation network comprises the first isolation capacitor. In some embodiments, the power divider further includes a second delta- or star-connected isolation network connected between the first negative output terminal, the second negative output terminal, and the third negative output terminal, where the second delta- or star-connected isolation network comprises the second isolation capacitor.

In a second example embodiment, a differential Wilkinson power divider includes a positive trace comprising a first positive portion and a second positive portion; and a negative trace comprising a first negative portion and a second negative portion, where the first positive portion of the positive trace crosses the first negative portion of the negative trace, and the second positive portion of the positive trace crosses the second negative portion of the negative trace. In some embodiments, the first positive portion of the positive trace crosses the first negative portion of the negative trace at approximately a midpoint of the first positive portion and approximately a midpoint of the first negative portion, and the second positive portion of the positive trace crosses the second negative portion of the negative trace at approximately a midpoint of the second positive portion and approximately a midpoint of the second negative portion. In some embodiments, the first and second positive portions of the positive trace and the first and second negative portions of the negative trace have approximately equal lengths. In some embodiments, the first positive portion of the positive trace is connected to a positive input terminal and a first positive output of the power divider, and the first negative portion of the negative trace is connected to a negative input terminal and a first negative output of the power divider. In some embodiments, the second positive portion of the positive trace is connected to the positive input terminal and a second positive output of the power divider, and the second negative portion of the negative trace is connected to the negative input terminal and a second negative output of the power divider. In some embodiments, the positive trace is deposited in a first layer of the power divider and the negative trace is deposited in a second layer of the power divider. In some embodiments, the positive trace is substantially symmetric to the negative trace. In some embodiments, the positive trace further comprises a third positive portion; the negative trace further comprises a third negative portion; and the third positive portion of the positive trace crosses over the third negative portion of the negative trace. In some embodiments, the third positive portion of the positive trace crosses the third negative portion of the negative trace at approximately a midpoint of the third positive portion and approximately a midpoint of the third negative portion. In some embodiments, the first, second and third positive portions of the positive trace and the first, second, and third negative portions of the negative trace have approximately equal lengths. In some embodiments, the first positive portion of the positive trace is connected to a positive input terminal and a first positive output of the power divider, and the first negative portion of the negative trace is connected to a negative input terminal and a first negative output of the power divider; the second positive portion of the positive trace is connected to the positive input terminal and a second positive output of the power divider, and the second negative portion of the negative trace is connected to the negative input terminal and a second negative output of the power divider; and the third positive portion of the positive trace is connected to the positive input terminal and a third positive output of the power divider, and the third negative portion of the negative trace is connected to the negative input terminal and a third negative output of the power divider. In some embodiments, the first and third positive portions of the positive trace include segments perpendicular to the second positive portion of the positive trace, and the second positive output and the second negative output of the power divider extend beyond the first positive output, the first negative output, the third positive output, and the third negative output of the power divider. In some embodiments, the differential Wilkinson power divider further includes an input shunt capacitor between a positive input terminal and a negative input terminal; a first isolation capacitor between a first positive output terminal and a second positive output terminal; and a second isolation capacitor between a first negative output terminal and a second negative output terminal. In some embodiments, the positive trace is in a first plane and the negative trace is in a second plane spaced apart from the first plane.

In a third example embodiment, a method of assembling a Wilkinson power divider includes connecting an input shunt capacitor between a positive input terminal and a negative input terminal; connecting a first isolation capacitor between a first positive output terminal and a second positive output terminal; and connecting a second isolation capacitor between a first negative output terminal and a second negative output terminal, where the first positive output terminal and the second positive output terminal are connected to a first trace in a first plane, and the first negative output terminal and the second negative output terminal are connected to a second trace in a second plane spaced apart from the first plane. In some embodiments, the method further includes configuring the power divider to function as a low-pass filter. In some embodiments, the method further includes connecting a first delta- or star-connected isolation network between the first positive output terminal, the second positive output terminal, and a third positive output terminal, where the first delta- or star-connected isolation network comprises the first isolation capacitor. In some embodiments, the method further includes connecting a second delta- or star-connected isolation network between the first negative output terminal, the second negative output terminal, and a third negative output terminal, where the second delta- or star-connected isolation network comprises the second isolation capacitor.

In a fourth example embodiment, a differential Wilkinson power divider includes an input shunt capacitor between a positive input terminal and a negative input terminal; a first isolation capacitor between a first positive output terminal and a second positive output terminal; and a second isolation capacitor between a first negative output terminal and a second negative output terminal, wherein the first positive output terminal and the second positive output terminal are connected to a first trace in a first plane, and the first negative output terminal and the second negative output terminal are connected to a second trace in a second plane spaced apart from the first plane, and wherein a first positive portion of the first trace crosses a first negative portion of the second trace, and a second positive portion of the first trace crosses a second negative portion of the second trace. In some embodiments, the first trace is substantially symmetric to the second trace.

DETAILED DESCRIPTION

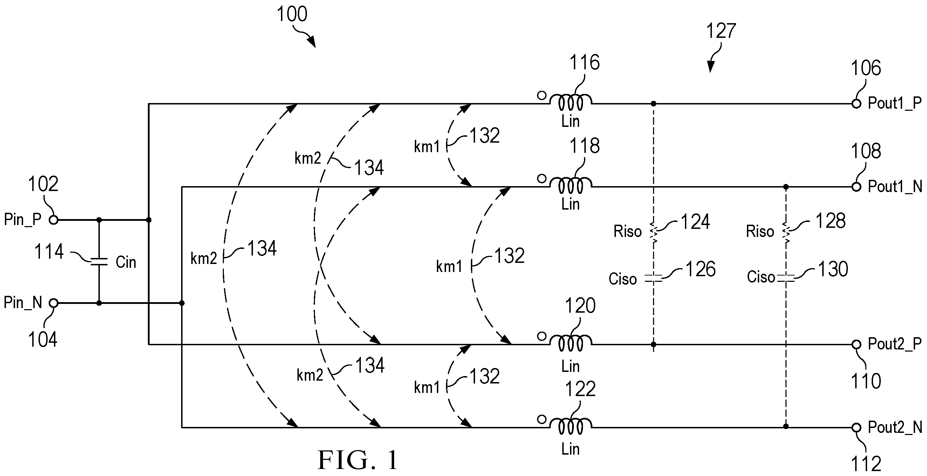

FIGS. 1-6 illustrate systems and techniques for implementing 2-way, 3-way, or N-way (e.g., 4-or-more-way) Wilkinson power dividers or combiners with balanced outputs (or respectively inputs), e.g., equal amplitude outputs in-phase with one another, high performance characteristics, and compact form factors. In some embodiments, a first positive output terminal and a second positive output terminal of a power divider are connected to a positive trace in a first plane, and a first negative output terminal and a second negative output terminal are connected to a negative trace in a second plane spaced apart from the first plane, e.g., in different circuit layers, with minimal overlap and crossings of positive and negative portions of the traces near the midpoints of the traces. Crossings may appear an even or odd number of times throughout the lines but are provided symmetrically for each of two (or more) outputs. This configuration provides separation between the various portions of the traces, which, along with the crossings, helps to ensure good balance at the output ports of the power divider and minimizes mutual coupling between the traces. In some embodiments, the positive and negative traces are substantially symmetric to one another, which also helps to ensure good balance at the output ports of the power divider. Cascading various ones of the power dividers disclosed herein enables implementation of N-way Wilkinson power dividers having a compact circuit layout and a minimal on-chip footprint.

FIG. 1 is a circuit diagram of a two-way differential power divider 100 in accordance with some embodiments, which functions substantially as a Wilkinson power divider, as, in some embodiments, it provides isolation between the output ports while maintaining a matched condition on all ports, e.g., such that the impedance at each port is equal to the impedance of each other port. As shown in FIG. 1, the two-way differential power divider 100 includes a positive input terminal 102 and a negative input terminal 104, sometimes referred to as positive and negative input ports. Differential circuits are typically designed to reject common-mode noise that affects both input traces similarly, while differential Wilkinson splitters are designed to duplicate two input signals, such as the positive input terminal 102 and the negative input terminal 104 of the two-way differential power divider 100 of FIG. 1, with minimal insertion loss between the input and output ports and with high isolation between two output ports.

To provide the input signals as duplicated sets of output signals, the two-way differential power divider 100 further includes a first positive output terminal 106 and a first negative output terminal 108 corresponding to the first positive output terminal 106, as well as a second positive output terminal 110 and a second negative output terminal 112 corresponding to the second positive output terminal 110, sometimes referred to as sets of positive and negative output ports. Notably, although the input and output terminals, e.g., the first positive input terminal 102 and the first positive output terminal 106, of the two-way differential power divider 100 are described as input and output terminals, respectively, as discussed above, Wilkinson power dividers are typically reversible and often referred to as either a Wilkinson power splitter or combiner depending on how they are utilized in a circuit.

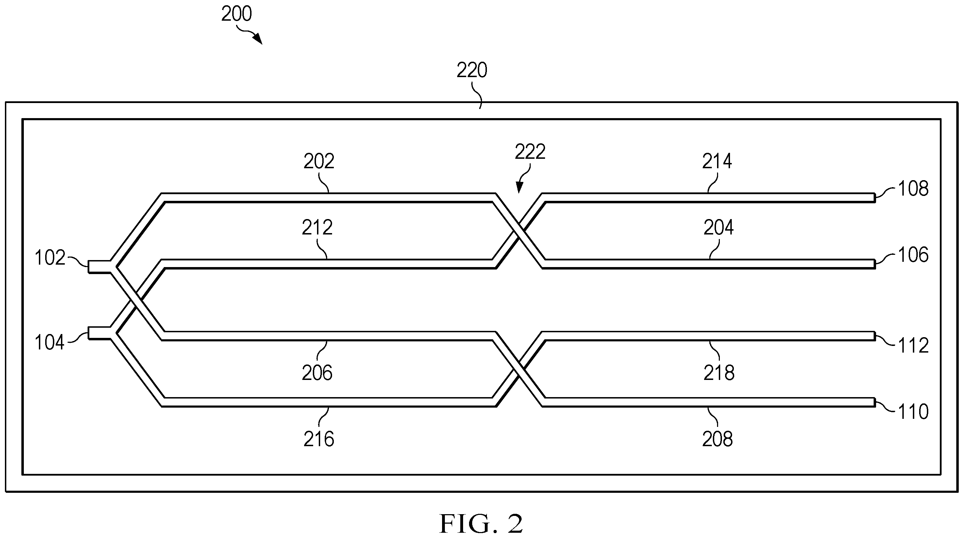

Accordingly, in some embodiments where the two-way differential power divider 100 is used as a power combiner rather than as a power splitter, the terminals of the two-way differential power divider 100 referred to as "input" terminals, such as the first positive input terminal 102, are instead used and function as outputs, while the terminals referred to as "output" terminals, such as the first positive output terminal 106, are instead used and function as inputs. As discussed further hereinbelow in connection with FIG. 2, in some embodiments, the first positive output terminal 106 and the second positive output terminal 110 are connected to a first trace in a first plane, and the first negative output terminal 108 and the second negative output terminal 112 are connected to a second trace in a second plane spaced apart from the first plane. Separating the traces of the output terminals in this way can minimize the capacitive coupling between the traces, increase the odd-mode characteristic impedance of the traces, and help to ensure impedance matching at the output ports of the power divider 100. Notably, in some embodiments, only the positive trace or the negative trace is used to provide a single-ended topology.

The two-way differential power divider 100 further includes an input shunt capacitor 114 between the positive input terminal 102 and the negative input terminal 104 to provide input electrostatic discharge protection, and, in some embodiments, to function as part of a frequency pass, e.g., low-pass, filter circuit in conjunction with input inductors associated with each of the output terminals. For example, in some embodiments, a first input inductor 116 is associated with the first positive output terminal 106, a second input inductor 118 is associated with the first negative output terminal 108, a third input inductor 120 is associated with the second positive output terminal 110, and a fourth input inductor 122 is associated with the second negative output terminal 112.

In some embodiments, in order to provide isolation between the outputs, a first isolation network is connected between the first positive output terminal 106 and the second positive output terminal 110, and a second isolation network is connected between the first negative output terminal 108 and the second negative output terminal 112. As shown in FIG. 1, in some embodiments, the isolation networks 127 include a resistor and a capacitor. For example, the isolation network connected between the first positive output terminal 106 and the second positive output terminal 110 includes a first isolation resistor 124 in series with a first isolation capacitor 126. Similarly, the isolation network connected between the first negative output terminal 108 and the second negative output terminal 112 includes a second isolation resistor 128 in series with a second isolation capacitor 130. However, in some embodiments, the isolation network may include resistors connected in parallel with capacitors.

In some embodiments, various mutual inductances, such as a mutual inductance 132 ($k_{m1}$) between pairs of adjacent input inductors 116, 118, 120, and 122 and a mutual inductance 134 ($k_{m2}$) between pairs of non-adjacent input inductors 116, 118, 120, and 122 exist in the two-way differential power divider 100. Although the mutual inductance between pairs of adjacent input inductors 116, 118, 120, and 122 is indicated as a single value in FIG. 1 and a mutual inductance 134 between pairs of non-adjacent input inductors 116, 118, 120, and 122 is indicated as a single value in FIG. 1, depending on implementation, a number of different mutual inductances may exist between pairs of adjacent input inductors 116, 118, 120, and 122 and pairs of non-adjacent input inductors 116, 118, 120, and 122. Although the specific, actual values for the resistors, capacitors, and inductors of the two-way differential power divider 100 will vary, and thus will need to be selected in accordance with specific implementations and tolerances, in some embodiments, these components are selected in accordance with the following equations 1-4, where Z0 is the interface impedance of the input and output terminals and $\omega$ is the targeted angular frequency. As shown in FIG. 1, Cin represents a value for the input shunt capacitor 114, Lin represents a value for the input inductors 116, 118, 120, 122, Ciso represents a value for the isolation capacitors 126, 130, and Riso represents a value for the isolation resistors 124, 128.

$$\mathrm{Lin} = \mathrm{Z0}/2/\omega/(1\text{-}k_{m1}) \tag{1}$$

$$\mathrm{Cin} = 1/\mathrm{Z0}/\omega \tag{2}$$

$$\mathrm{Ciso} = 2(1+k_{m1})^2/\mathrm{Z0}/\omega/(1\text{-}k_{m1}^2) \tag{3}$$

$$\mathrm{Riso} = \mathrm{Z0}/2*(1+k_{m1})^2/(1+k_{m1}^2) \tag{4}$$

FIG. 2 is a top view of a two-way differential power divider 200 such as the two-way differential power divider 100 of FIG. 1 in accordance with some embodiments. As shown in FIG. 2, in some embodiments, the positive input terminal 102, the first positive output terminal 106, and the second positive output terminal 110 of a two-way differential power divider are connected to a positive trace comprising a first positive portion including a first segment 202 and a second segment 204 and a second positive portion including a third segment 206 and a fourth segment 208. As also shown in FIG. 2, in some embodiments, the negative input terminal 104, the first negative output terminal 108, and the second negative output terminal 112 of a two-way differential power divider 100 are connected to a negative trace comprising a first negative portion including a fifth segment 212 and a sixth segment 214 and a second negative portion including a seventh segment 216 and an eighth segment 218. In some embodiments, the power divider 200 also includes an electrical ground grid 220 to improve common-mode rejection and/or to absorb electromagnetic interference from other components.

In some embodiments, as noted above in connection with FIG. 1, the positive trace is deposited in a first plane, such as a first circuit layer, and the negative trace is deposited in a second plane, such as a second circuit layer, spaced apart from the first plane. As shown in FIG. 2, in some embodiments, the first positive portion of the positive trace crosses the first negative portion of the negative trace, and the second positive portion of the positive trace crosses the second negative portion of the negative trace at approximately a midpoint 222 of the first and second positive portions of the positive trace, e.g., where the first segment 202 and the second segment 204 connect, and of the first and second negative portions of the negative trace, e.g., where the fifth segment 212 and the sixth segment 214 connect. These crossings of the positive and negative traces help to limit mutual coupling between the traces, and thus help to ensure balanced outputs for the power divider 200. In some embodiments, the midpoint 222 is a substantially exact midpoint of the first and second positive portions of the positive trace and of the first and second negative portions of the negative trace. However, in some embodiments, the midpoint 222 may be spaced from an exact midpoint of the first and/or second positive portions of the positive trace and/or of the first and/or second negative portions of the negative trace by up to 2%, up to 5%, up to 10%, or up to 15% of the length of any one of the first and/or second positive portions of the positive trace and/or of the first and/or second negative portions of the negative trace. In some embodiments, there is more than one crossing and the positions of the crossings are distributed equally along the lines. Generally, the crossings are distributed on all the output paths in substantially the same manner to maintain symmetry.

In some embodiments, as shown in FIG. 2, the first and second positive portions of the positive trace and the first and second negative portions of the negative trace have approximately equal lengths. In some embodiments, the first segment 202, the second segment 204, the third segment 206, the fourth segment 208, the fifth segment 212, the sixth segment 214, the seventh segment 216, and the eighth segment 218 all have approximately equal lengths. However, in some embodiments, the lengths of two or more segments vary by up to 2%, up to 5%, up to 10%, or up to 15%. Additionally, as can be seen in FIG. 2, in some embodiments, the positive trace is substantially symmetric to the negative trace. For example, rotating the positive trace about its longitudinal axis produces a shape substantially identical to the shape of the negative trace.

To complete the two-way differential power divider 200, the input capacitor 114 is connected between the positive input terminal 102 and the negative input terminal 104 and isolation networks 127 (e.g., comprising isolation resistors 124, 128 and isolation capacitors 126, 130) are connected between the positive and negative output ports of the power divider 200. Notably, in some embodiments, the transmission lines formed by the first and second positive portions of the positive trace and the first and second negative portions of the negative trace produce the various input inductors 116, 118, 120, 122. By arranging the various traces in accordance with the layout of FIG. 2 and including the input capacitor 114 and isolation networks 127 shown in FIG. 1, the two-way differential power divider 100 is fully realized. Notably, in some embodiments, the first isolation resistor 124 and the second isolation resistor 128 of the two-way differential power divider 100 are implemented using trace resistances; however, in some embodiments, these resistances are provided as or augmented with discrete resistors and/or capacitors.

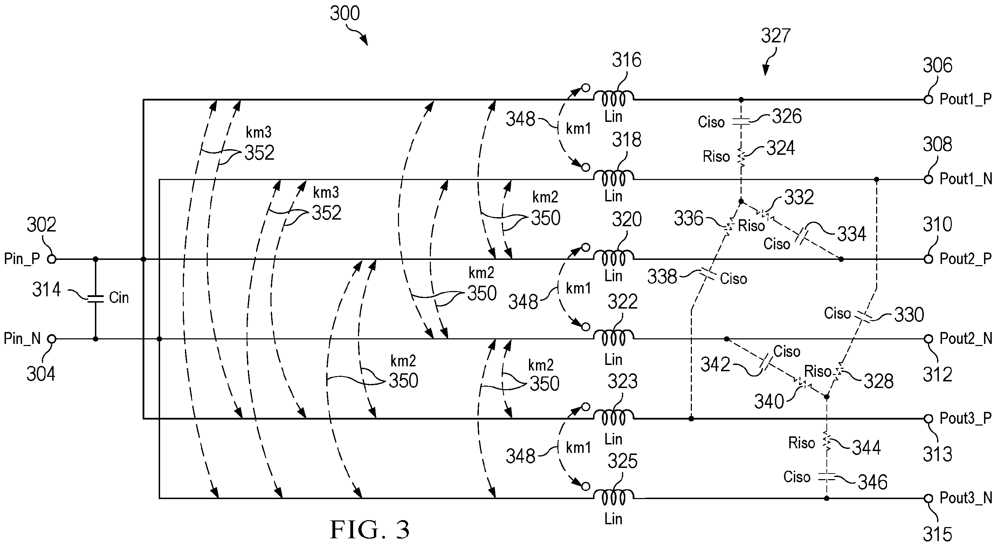

FIG. 3 is a circuit diagram of a three-way differential power divider 300 using a star-connected isolation network in accordance with some embodiments. As will be appreciated from a comparison between FIG. 1 and FIG. 3, the three-way differential power divider 300 includes many similar components to those of the two-way differential power divider 100 of FIG. 1. For example, the three-way differential power divider 300 of FIG. 3 includes a positive input terminal 302 and a negative input terminal 304, a first positive output terminal 306 and a first negative output terminal 308, a second positive output terminal 310 and a second negative output terminal 312, and, differing from the two-way differential power divider 100 of FIG. 1, additionally includes a third positive output terminal 313 and a third negative output terminal 315.

Like the two-way differential power divider 100 of FIG. 1, each of the output terminals of the three-way differential power divider 300 is associated with an input inductor, i.e., input inductors 316, 318, 320, 322, 323, and 325, and isolation networks 327 are provided to isolate the output terminals from one another. In the example of the three-way differential power divider 300 of FIG. 3, as noted above, star-connected isolation networks 327 are provided between the respective positive and negative output terminals comprising a number of isolation resistors and isolation capacitors, i.e., isolation resistors 324, 328, 332, 336, 340, and 344 and isolation capacitors 326, 330, 334, 338, 342, and 346. Additionally, each pair of input inductors 316, 318, 320, 322, 323, and 325 have an associated mutual inductance, e.g., mutual inductances 348, 350, and 352, which, although shown as only three values in FIG. 3 for simplicity, may vary for each pair of input inductors. However, in some embodiments, the mutual inductances 348 between respective pairs of positive and negative output ports, are equal or substantially equal. The specific, actual values for the resistors, capacitors, and inductors of the three-way differential power divider 300 will vary, and thus will need to be selected in accordance with specific implementations and tolerances. In some embodiments, as will be appreciated by those of ordinary skill in the art, delta-connected isolation networks are used in place of one or more of the star-connected isolation networks 327 of FIG. 3. A delta connection forms a closed loop with three nodes, while a star (or wye) connection has one common central point with each node connected to it. In some implementations, a star-connected isolation network has fewer interfaces with the output terminals and smaller component values, but either a delta- or star-connected can be used depending on specific implementations.

In some embodiments, two or more of the two-way differential power divider 100 of FIG. 1 and the three-way differential power divider 300 of FIG. 3 are cascaded to provide non-binary splitting ratios. For example, in some embodiments, a three-way differential power divider is cascaded with three two-way differential power dividers to provide a six-way differential power divider. Generally, two-way and three-way differential power dividers can be cascaded to provide any required number of outputs, and those of ordinary skill in the art will understand that the differential power dividers taught herein, such as the three-way differential power divider 300 of FIG. 3, can be extended along similar lines of the expansion from the two-way differential power divider 100 of FIG. 1 to the three-way differential power divider 300 of FIG. 3 to four-way differential power dividers, five-way differential power dividers, and so on. Accordingly, in some embodiments, by expanding the design of the three-way differential power divider 300 of FIG. 3 and/or by cascading multiple differential power dividers, an N-way differential power divider can be produced having any desired number of outputs in accordance with the teachings herein.

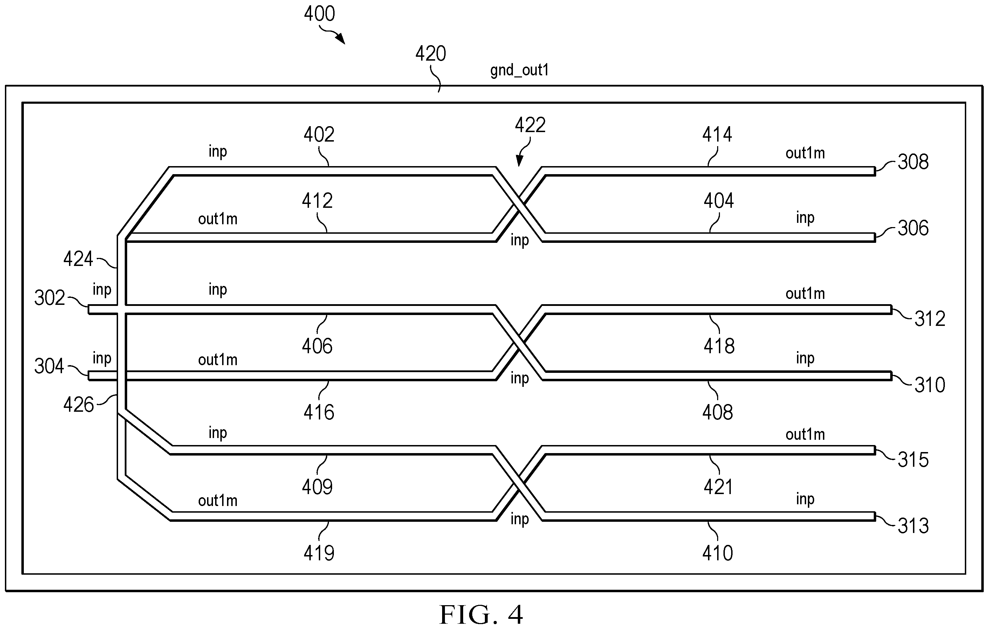

FIG. 4 is a top view of a three-way differential power divider 400 such as the three-way differential power divider 300 of FIG. 3 in accordance with some embodiments. As will be appreciated from a comparison between FIG. 2 and FIG. 4, the three-way differential power divider 400 includes many similar components to those of the two-way differential power divider 200 of FIG. 2. For example, as shown in FIG. 4, the positive input terminal 302, the first positive output terminal 306, and the second positive output terminal 310 of the three-way differential power divider 400 are connected to a positive trace comprising a first positive portion including a first segment 402 and a second segment 404 and a second positive portion including a third segment 406 and a fourth segment 408. As also shown in FIG. 4, in some embodiments, the negative input terminal 304, the first negative output terminal 308, and the second negative output terminal 312 of the three-way differential power divider 400 are connected to a negative trace comprising a first negative portion including a fifth segment 412 and a sixth segment 414 and a second negative portion including a seventh segment 416 and an eighth segment 418. In some embodiments, the power divider 400 also includes an electrical ground grid 420 to improve common-mode rejection and/or to absorb electromagnetic interference from other components.

In contrast with the two-way differential power divider 200 of FIG. 2, the three-way differential power divider 400 additionally includes a third positive output terminal 313 connected to the positive input terminal 302 and the positive trace and a third negative output terminal 315 connected to the negative input terminal 304 and the negative trace. As shown in FIG. 4, the positive trace includes a third positive portion including a ninth segment 409 and a tenth segment 410 connected between the positive input terminal 302 and the third positive output terminal 313, and the negative trace includes a third negative portion including an eleventh segment 419 and a twelfth segment 421 connected between the negative input terminal 304 and the third negative output terminal 315.

In some embodiments, as noted above in connection with FIG. 1, the positive trace is deposited in a first plane, such as a first circuit layer, and the negative trace is deposited in a second plane, such as a second circuit layer, spaced apart from the first plane. As shown in FIG. 4, in some embodiments, the first positive portion of the positive trace crosses the first negative portion of the negative trace, the second positive portion of the positive trace crosses the second negative portion of the negative trace, and the third positive portion of the positive trace crosses the third negative portion of the negative trace proximate to approximately a midpoint 422 of the first and third positive portions of the positive trace, e.g., where the first segment 402 and the second segment 404 connect, and of the first and third negative portions of the negative trace, e.g., where the fifth segment 412 and the sixth segment 414 connect. These crossings of the positive and negative traces help to limit mutual coupling between the traces, and thus help to ensure balanced outputs for the power divider 400. In some embodiments, the midpoint 422 is a substantially exact midpoint of the first and third positive portions of the positive trace and of the first and third negative portions of the negative trace. However, in some embodiments, the midpoint 222 may be spaced from an exact midpoint of the first and/or third positive portions of the positive trace and/or of the first and/or third negative portions of the negative trace by, e.g., up to 2%, up to 5%, up to 10%, or up to approximately 15% of the length of any one of the first and/or third positive portions of the positive trace and/or of the first and/or third negative portions of the negative trace. In some embodiments, there is more than one crossing and the positions of the crossings are distributed equally along the lines. Generally, the crossings are distributed on all the output paths in substantially the same manner to maintain symmetry.

In some embodiments, as shown in FIG. 4, the first, second, and third positive portions of the positive trace and the first, second, and third negative portions of the negative trace have approximately equal lengths. In some embodiments, the first segment 402, the second segment 404, the third segment 406, the fourth segment 408, the fifth segment 412, the sixth segment 414, the seventh segment 416, the eighth segment 418, the ninth segment 409, the tenth segment 410, the eleventh segment 419, and the twelfth segment 421 all have approximately equal lengths. However, in some embodiments, the lengths of two or more segments vary by, e.g., up to 2%, up to 5%, up to 10%, or up to approximately 15%. Additionally, as can be seen in FIG. 2, in some embodiments, the positive trace is substantially symmetric to the negative trace. For example, rotating the positive trace about its longitudinal axis produces a shape substantially identical to the shape of the negative trace.

Notably, in some embodiments, the first and third positive portions of the positive trace include segments 424, 426 perpendicular to the second positive portion of the positive trace and the first and third negative portions of the negative trace include similar segments. Due to this, the second positive output 310 and the second negative output 312 of the power divider extend beyond the first positive output 306, the first negative output 308, the third positive output 313, and the third negative output 315 of the power divider. This configuration provides separation between the various portions of the traces while maintaining equal lengths of the first, second, and third portions of the positive and negative traces, which, along with the crossings of the first, second and third portions proximate to the midpoint 422, helps to ensure good balance at the output ports of the power divider 400. Notably, as the second positive and negative portions do not include perpendicular segments like segments 424, 426 of the first and third positive and negative portions of the positive and negative traces, in some embodiments, the midpoint of the second positive and negative portions is offset from the midpoint 422 of the first and third positive and negative portions. Accordingly, in some embodiments, the second positive and negative portions cross at a point slightly displaced from the midpoint 422 of the first and third positive negative portions, i.e., closer to the output ports of the power divider 400.

To complete the two-way differential power divider 400, the input capacitor 314 is connected between the positive input terminal 302 and the negative input terminal 304 and star- or delta-connected isolation networks, such as the isolation networks 237 of FIG. 3 (e.g., comprising isolation resistors 324, 328, 332, 336, 340, and 344 and isolation capacitors 326, 330, 334, 338, 342, and 346), are connected between the positive and negative output ports of the power divider 400. Notably, in some embodiments, the transmission lines formed by the first, second, and third positive portions of the positive trace and the first, second, and third negative portions of the negative trace produce the various input inductors 316, 318, 320, 322, 323, and 325. By arranging the various traces in accordance with the layout of FIG. 4 and including the input capacitor 314 and isolation networks 327 shown in FIG. 3, the three-way differential power divider 300 is fully realized. Notably, in some embodiments, the isolation resistors 324, 328, 332, 336, 340, and 344 of the three-way differential power divider 100 are implemented using trace resistances; however, in some embodiments, these resistances are provided as or augmented with discrete resistors and/or capacitors.

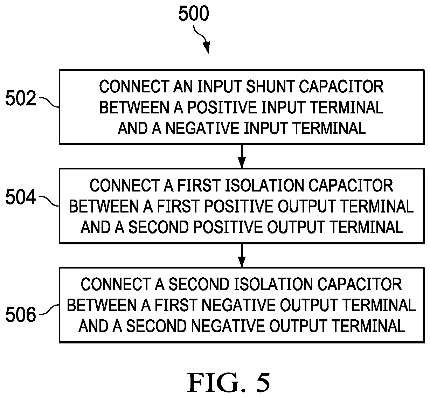

FIG. 5 is a flow diagram of a method 500 of assembling a differential Wilkinson power divider, such as one of the differential power dividers of FIGS. 1-4, in accordance with some embodiments. As shown in FIG. 5, at block 502, an input shunt capacitor, such as one of the input shunt capacitors 114, 314 of FIGS. 1 and 3, is connected between a positive input terminal and a negative input terminal, such as one of the positive and negative input terminals 102, 104, 302, and 304 of FIGS. 1 and 3. At block 504, a first isolation capacitor, such as the isolation capacitor 126 of FIG. 1, is connected between a first positive output terminal and a second positive output terminal, such as one of the first and second positive output terminals 106, 110, and the isolation capacitor 326 of FIG. 3 is connected in a star (or wye) configuration between a first positive output terminal and the two other positive output terminals 306, 310 of FIG. 3. At block 506, a second isolation capacitor, such as the isolation capacitors 130 of FIG. 1, is connected between a first negative output terminal and a second negative output terminal, such as one of the first and second negative output terminals 108, 112 of FIG. 1, and the isolation capacitor 330 of FIG. 3 is connected in a star (or wye) configuration between a first negative output terminal and the two other negative output terminals 308, 312 of FIG. 3. In some embodiments, the first positive output terminal and the second positive output terminal are connected to a first trace in a first plane or circuit layer, and the first negative output terminal and the second negative output terminal are connected to a second trace in a second plane or circuit layer spaced apart from the first plane or circuit layer.

In some embodiments, the method 500 includes configuring the power divider to function as a low-pass filter. In some embodiments, the method 500 includes connecting a first delta- or star-connected isolation network, such as the isolation networks 327 of FIG. 3, between the first positive output terminal, the second positive output terminal, and a third positive output terminal, wherein the first isolation network comprises the first isolation capacitor. In some embodiments, the method 500 includes connecting a second delta- or star-connected isolation network between the first negative output terminal, the second negative output terminal, and a third negative output terminal, wherein the second isolation network comprises the second isolation capacitor.

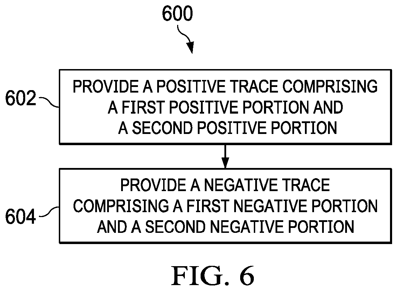

FIG. 6 is a flow diagram of a method 600 of arranging traces in a Wilkinson differential power divider, such as one of the differential power dividers of FIGS. 1-4, in accordance with some embodiments. As shown in FIG. 6, at block 602, a positive trace comprising a first positive portion and a second positive portion is provided, as shown in FIGS. 2 and 4. At block 604, a negative trace comprising a first negative portion and a second negative portion is provided, as shown in FIGS. 2 and 4. In some embodiments, the first positive portion of the positive trace is configured to cross the first negative portion of the negative trace, and the second positive portion of the positive trace is configured to cross the second negative portion of the negative trace, as shown in FIGS. 2 and 4.

In some embodiments, certain aspects of the techniques described above, such as the methods 500, 600, may be implemented by one or more processors of a processing system executing software. The software comprises one or more sets of executable instructions stored or otherwise tangibly embodied on a non-transitory computer readable storage medium. The software can include the instructions and certain data that, when executed by the one or more processors, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disk, magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed are not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A differential Wilkinson power divider, comprising:

   a positive trace comprising a first positive portion and a second positive portion; and
   a negative trace comprising a first negative portion and a second negative portion,
   wherein the first positive portion of the positive trace crosses the first negative portion of the negative trace, and the second positive portion of the positive trace crosses the second negative portion of the negative trace.

2. The differential Wilkinson power divider of claim 1, wherein the first positive portion of the positive trace crosses the first negative portion of the negative trace at approximately a midpoint of the first positive portion and approximately a midpoint of the first negative portion, and the second positive portion of the positive trace crosses the second negative portion of the negative trace at approximately a midpoint of the second positive portion and approximately a midpoint of the second negative portion.

3. The differential Wilkinson power divider of claim 1 or 2, wherein the first and second positive portions of the positive trace and the first and second negative portions of the negative trace have approximately equal lengths.

4. The differential Wilkinson power divider of any of claims 1 to 3, wherein the first positive portion of the positive trace is connected to a positive input terminal and a first positive output of the power divider, and the first negative portion of the negative trace is connected to a negative input terminal and a first negative output of the power divider.

5. The differential Wilkinson power divider of claim 4, wherein the second positive portion of the positive trace is connected to the positive input terminal and a second positive output of the power divider, and the second negative portion of the negative trace is connected to the negative input terminal and a second negative output of the power divider.

6. The differential Wilkinson power divider of any of claims 1 to 5, wherein the positive trace is deposited in a first layer of the power divider and the negative trace is deposited in a second layer of the power divider.

7. The differential Wilkinson power divider of any of claims 1 to 6, wherein the positive trace is substantially symmetric to the negative trace.

8. The differential Wilkinson power divider of any of claims 1 to 7, wherein:

   the positive trace further comprises a third positive portion;
   the negative trace further comprises a third negative portion; and
   the third positive portion of the positive trace crosses over the third negative portion of the negative trace.

9. The differential Wilkinson power divider of claim 8, wherein the third positive portion of the positive trace crosses the third negative portion of the negative trace at approximately a midpoint of the third positive portion and approximately a midpoint of the third negative portion.

10. The differential Wilkinson power divider of claim 8, wherein the first, second and third positive portions of the positive trace and the first, second, and third negative portions of the negative trace have approximately equal lengths.

**11.** The differential Wilkinson power divider of claim 8, wherein:

the first positive portion of the positive trace is connected to a positive input terminal and a first positive output of the power divider, and the first negative portion of the negative trace is connected to a negative input terminal and a first negative output of the power divider;

the second positive portion of the positive trace is connected to the positive input terminal and a second positive output of the power divider, and the second negative portion of the negative trace is connected to the negative input terminal and a second negative output of the power divider; and

the third positive portion of the positive trace is connected to the positive input terminal and a third positive output of the power divider, and the third negative portion of the negative trace is connected to the negative input terminal and a third negative output of the power divider.

**12.** A differential Wilkinson power divider, comprising:

an input shunt capacitor between a positive input terminal and a negative input terminal;

a first isolation capacitor between a first positive output terminal and a second positive output terminal; and

a second isolation capacitor between a first negative output terminal and a second negative output terminal, wherein the first positive output terminal and the second positive output terminal are connected to a first trace in a first plane, and the first negative output terminal and the second negative output terminal are connected to a second trace in a second plane spaced apart from the first plane.

**13.** The differential Wilkinson power divider of claim 12, wherein the power divider is configured to function as a low-pass filter.

**14.** The differential Wilkinson power divider of claim 12 or 13, further comprising:

a third positive output terminal and a third negative output terminal corresponding to the third positive output terminal; and

a first delta- or star-connected isolation network connected between the first positive output terminal, the second positive output terminal, and the third positive output terminal, wherein the first delta- or star-connected isolation network comprises the first isolation capacitor.

**15.** The differential Wilkinson power divider of claim 14, further comprising:

a second delta- or star-connected isolation network connected between the first negative output terminal, the second negative output terminal, and the third negative output terminal, wherein the second delta- or star-connected isolation network comprises the second isolation capacitor.

FIG. 1

FIG. 2

FIG. 3

FIG. 4

EP 4 734 278 A1

500

| 502 | CONNECT AN INPUT SHUNT CAPACITOR BETWEEN A POSITIVE INPUT TERMINAL AND A NEGATIVE INPUT TERMINAL |
| 504 | CONNECT A FIRST ISOLATION CAPACITOR BETWEEN A FIRST POSITIVE OUTPUT TERMINAL AND A SECOND POSITIVE OUTPUT TERMINAL |
| 506 | CONNECT A SECOND ISOLATION CAPACITOR BETWEEN A FIRST NEGATIVE OUTPUT TERMINAL AND A SECOND NEGATIVE OUTPUT TERMINAL |

FIG. 5

600

PROVIDE A POSITIVE TRACE COMPRISING
A FIRST POSITIVE PORTION AND
A SECOND POSITIVE PORTION

602

PROVIDE A NEGATIVE TRACE
COMPRISING A FIRST NEGATIVE PORTION
AND A SECOND NEGATIVE PORTION

604

## FIG. 6

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/069949 A1 (YOON SEUNGHWAN [US]) 9 March 2017 (2017-03-09) | 1-7 | INV. H01P5/16 |
| A | * paragraph [0003] * * paragraph [0021] - paragraph [0022] * * paragraph [0024] - paragraph [0040]; figures 1-3D * | 8-11 | |
| X | CN 114 824 720 A (UESTC) 29 July 2022 (2022-07-29) | 12,13 | |
| A | * abstract; figures 1,2(a), 2(b) * | 14,15 | |
| X | EP 4 072 012 A1 (HUAWEI TECH CO LTD [CN]) 12 October 2022 (2022-10-12) | 12,13 | |
| A | * paragraph [0084] - paragraph [0089]; figures 7-8(b) * | 14,15 | |
| A | CHOI UI-GYU ET AL: "A D-Band Two-Way Differential Power Divider on 65-nm CMOS Process", IEEE MICROWAVE AND WIRELESS TECHNOLOGY LETTERS, IEEE, vol. 34, no. 3, 1 March 2024 (2024-03-01), pages 279-282, XP011962975, ISSN: 2771-957X, DOI: 10.1109/LMWT.2024.3353483 [retrieved on 2024-01-25] * Abstract I. Introduction II. Circuit design and implementation; page 279 - page 280; figure 4 * | 1-11 | **TECHNICAL FIELDS SEARCHED (IPC)** H01P |
| A | CN 114 421 112 A (CHONGQING MICROELECTRONIC CENTER OF BEIJING SCIENCE AND TECHNOLOGY UNI) 29 April 2022 (2022-04-29) * abstract; figures 1-4 * | 1-11 | |

-/--

The present search report has been drawn up for all claims

| Place of search | Date of completion of the search | Examiner |
|---|---|---|
| The Hague | 10 July 2025 | Pastor Jiménez, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 24 30 6784

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/214700 A1 (WANG XUDONG [US] ET AL) 11 July 2019 (2019-07-11) <br> * paragraph [0033] - paragraph [0034]; figure 1 * <br> * paragraph [0094] - paragraph [0100]; figure 15 * <br> ----- | 1-11 | |
| | | | **TECHNICAL FIELDS SEARCHED** (IPC) |

The present search report has been drawn up for all claims

| Place of search | Date of completion of the search | Examiner |
|---|---|---|
| The Hague | 10 July 2025 | Pastor Jiménez, J |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

Europäisches
Patentamt

European
Patent Office

Office européen
des brevets

**Application Number**

EP 24 30 6784

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

| | | |
|---|---|---|
| Europäisches Patentamt European Patent Office Office européen des brevets | **LACK OF UNITY OF INVENTION** **SHEET B** | **Application Number** **EP 24 30 6784** |

The Search Division considers that the present European patent application does not comply with the requirements of unity of invention and relates to several inventions or groups of inventions, namely:

> 1. claims: 1-11
>
>> A differential Wilkinson power divider comprising a positive and negative traces wherein crosses between the traces are present.
>> ---
>
> 2. claims: 12-15
>
>> A differential Wilkinson power divider with a distribution of capacitors between the input and output terminals and a multilayer placement of the traces.
>> ---

## ANNEX TO THE EUROPEAN SEARCH REPORT
## ON EUROPEAN PATENT APPLICATION NO.

EP 24 30 6784

This annex lists the patent family members relating to the patent documents cited in  the above-mentioned European search report.
The members are as contained in the European Patent Office EDP file on
The European Patent Office is in no way liable for these particulars which are merely given for the purpose of information.

10-07-2025

| Patent document cited in search report | Publication date | Patent family member(s) | | Publication date |
|---|---|---|---|---|
| US 2017069949 A1 | 09-03-2017 | NONE | | |
| CN 114824720 A | 29-07-2022 | NONE | | |
| EP 4072012 A1 | 12-10-2022 | CN | 114846744 A | 02-08-2022 |
| | | EP | 4072012 A1 | 12-10-2022 |
| | | WO | 2021134383 A1 | 08-07-2021 |
| CN 114421112 A | 29-04-2022 | NONE | | |
| US 2019214700 A1 | 11-07-2019 | CN | 209897017 U | 03-01-2020 |
| | | DE | 202019000042 U1 | 08-05-2019 |
| | | US | 2019214700 A1 | 11-07-2019 |

EPO FORM P0459

For more details about this annex : see Official Journal of the European Patent Office, No. 12/82